# EUROPÄISCHE PATENTSCHRIFT

(11) **EP 1 364 402 B1**
(45) Veröffentlichungstag und Bekanntmachung des Hinweises auf die Patenterteilung: **01.05.2013**
(21) Anmeldenummer: 01985836.4
(22) Anmeldetag: 01.12.2001
(51) Int. Cl.: H01L 23/373

(54) **LEISTUNGSMODUL MIT VERBESSERTEM TRANSIENTEN WÄRMEWIDERSTAND**
POWER MODULE HAVING IMPROVED TRANSIENT THERMAL IMPEDANCE
MODULE DE PUISSANCE PRESENTANT UNE IMPEDANCE THERMIQUE TRANSITOIRE AMELIOREE

(30) Priorität: 13.12.2000 DE 10062108
(43) Veröffentlichungstag der Anmeldung: 26.11.2003
(73) Patentinhaber: Infineon Technologies AG, 85579 Neubiberg (DE)
(72) Erfinder: TADROS, Yehia, 13465 Berlin (DE); PALM, Gerhard, 38173 Sickte (DE); THOBEN, Markus, 63071 Offenbach (DE)
(74) Vertreter: Schmuckermaier, Bernhard
(86) Internationale Anmeldenummer: PCT/EP2001/014058
(87) Internationale Veröffentlichungsnummer: WO 2002/049104

(56) Entgegenhaltungen:
- EP-A- 0 376 478
- EP-A- 0 862 209
- EP-A- 0 901 166
- DE-A- 19 647 590
- DE-A- 19 700 963
- FR-A- 2 786 657
- US-A- 5 966 291
- PATENT ABSTRACTS OF JAPAN vol. 008, no. 091 (E-241), 26. April 1984 (1984-04-26) -& JP 59 009953 A (MEIDENSHA KK), 19. Januar 1984 (1984-01-19)

## Beschreibung

Die Erfindung betrifft einen Aufbau aus einem elektronischen Leistungbauelement, wie z. B. einem Hochleistungsumrichter, einem IGBT, einem Leistungs-MOSFET, Leistungsdioden oder Kombinationen von Leistungsbauelementen auf einer DCB-Keramik. Die DCB Keramik des Leistungsbauelementes wird direkt mit einem Kühlkörper gekühlt, um die Verlustleistung des Leistungsbauelementes abzuführen.

Um den Wärmewiderstand zwischen Leistungsbauelement und elektrischer Kontaktschicht zu verringern hat man in der EP 0 242 626 B 1 vorgeschlagen, die Leistungsbauelemente an ihrer Unterseite mit einer Paste zu versehen, die in einem Lösungsmittel ein Metallpulver, vorzugsweise ein Silberpulver enthält, und diese vorbehandelten Leistungsbauelemente mit Hilfe eines Drucksinterverfahrens mit einer flächig ausgebildeten Kontaktschicht zu verbinden. Durch die flächig ausgebildeten Kontakte sowie durch die Verwendung von hochwämeleitfahigem Silber zur Kontaktierung konnte der Wärmeübergang zwischen Leistungsbauelement und Kontaktierungsschicht verbessert werden.

In EP 0 376 478 A2 ist eine Leistungshalbleiteranordnung beschrieben, bei der Leistungsbauelemente zwischen Wärmekapazitäten aus Metall angeordnet sind.

In EP 0 901 166 A1 ist ein Leistungshalbleitermodul mit in Submodulen integrierten Kühlem beschrieben. Der Kühler wird direkt auf ein Keramiksubstrat gegossen, wodurch eine feste Verbindung zwischen dem Metall des Kühlers und der Keramik des Substrates gebildet wird.

Weitere Verbesserungen der Kühlung von Leistungsbauelementen gelangen in der Vergangenheit mit sogenannten DCB-Keramiken (DCB = Direct Copper Bonding). In der DE 197 00 963 AI wird hierzu vorgeschlagen, auf ein beidseitig mit Kupfer kaschiertes Keramiksubstrat die Leistungsbauelemente auf die Oberseite der DCB-Keramik zu löten und die Unterseite der DCB-Keramik auf eine als Schaltungsträger wirkende Metallplatte zu löten. Diese Metallplatte gibt die Verlustwärme an ein angeschlossenes Kühlsystem weiter. Die obere Kupferschicht der DCB-Keramik wird strukturiert (unterbrochen), wodurch Leiterbahnen zur Kontaktierung der Leistungsbauelemente an ihrer Unterseite gebildet werden. Die weitere Kontaktierung der Leistungsbauelemente erfolgt an deren Oberseite mit Bonddrähten.

Wollte man die Vorzüge beider vorbeschriebenen Prozesse, einmal das Drucksintern von Leistungsbauelementen auf eine Kontaktierungsschicht und zum anderen das Auflöten einer DCB-Keramik auf eine, Metallplatte zur weiteren Verbindung der Metallplatte an ein Kühlsystem miteinander kombinieren, so müssten mindestens zwei verschiedene Prozesstechnologien für den Aufbau eines Leistungsbauelementes eingesetzt werden, nämlich Drucksintern und Löten. Zur Herstellung der Verbindung an ein Kühlsystem wird in der Regel noch eine weitere Prozeßtechnologie notwendig, da die metallische Grundplatte des Leistungsbauelementes in herkömmlicher Weise mit einer Wärmeleitpaste an das Kühlsystem angeschlossen wird. Der Einsatz mehrerer, verschiedener Prozeßteclnologien in der Aufbau- und Verbindungtechnik von Leistungsbauelementen macht den Herstellungsprozeß der Leistungsbauelemente jedoch aufwendig und teuer.

Ausgehend von dem vorbeschriebenen Stand der Technik stellt sich die erfindungsgemäße Aufgabe ein Leistungsmodul mit einem verbesserten thermischen Verhalten anzugeben, das gegenüber thermischen Lastwechseln weitgehend unempfindlich ist.

Erfindungsgemäß wird diese Aufgabe gelöst durch ein Leistungsmodul, dessen Aufbau lediglich mit dem Drucksinterverfahren verbunden ist. Zur zusätzlichen Verbesserung des transienten thermischen Verhaltens werden die Leistungsbauelemente mit zusätzlichen Wärmekapazitäten bestückt.

Ein erfindungsgemäßes elektronisches Leistungsmodul besteht aus mindestens einem elektronischen Leistungsbauelement, einem DCB-Keramiksubstrat, einem Kühlkörper und mindestens einer zusätzlichen Wärmekapazität, wobei
a) die elektronischen Leistungsbauelemente über eine Sinterschicht an ihrer Unterseite mit der oberen Kupferschicht des DCB-Keramiksubstrates verbunden sind,
b) die obere Kupferschicht des DCB-Keramiksubstrates zur elektrischen Kontaktierung der Leistungsbauelemente in Kupferleiterbahnen strukturiert ist,
c) die untere Kupferschicht des DCB-Keramiksubstrates über eine Sinterschicht mit einen Kühlkörper verbunden ist,
d) die Oberseiten der Leistungsbauelemente über eine Sinterschicht mit einer zusätzlichen Wärmekapazität verbunden sind.

Weitere vorteilhafte Ausführungsformen eines erfindungsgemäßen Leistungsmoduls sind in den Unteransprüchen enthalten.

Mit der Erfindung werden hauptsächlich die folgenden Vorteile erzielt:

Durch den Verzicht auf eine metallische Grundplatte, die im herkömmlichen Modulaufbau von Leistungsmodulen eingesetzt wird, um das Modul auf einen Kühlkörper zu montieren, wird die Wärmeabfuhr der Verlustwärme aus den Leistungsbauelementen in den Kühlkörper verbessert. Die direkte Verbindung der DCB-Keramik mit einem Kühlkörper verbessert den stationären thermischen Widerstand des erfindungsgemäßen Leistungsmoduls gegenüber herkömmlichen Aufbauten um bis zu 50%.

Durch das verringerte Volumen des Aufbaus aufgrund des Verzichts auf eine herkömmliche Grundplatte verringert sich auch die Wärmekapazität des Aufbaus, was für das transiente thermische Verhalten von Bedeutung ist. Um die verbesserten Wärmedurchgänge des erfindungsgemäßen Leistungsmoduls auch bei transienten Wärmebelastungen optimal auszunutzen, enthält das Leistungsmodul zusätzliche Wärmekapazitäten an der Oberfläche der Leistungsbauelemente. Hierdurch werden kurzzeitig auftretende Spitzenwerte der thermischen Verlustleistung in den Wärmekapazitäten zwischengepuffert und dadurch das transiente thermische Verhalten des Leistungsmoduls verbessert. Durch die direkt an den Leistungsbauelementen angeordneten Wärmekapazitäten wird der transiente thermische Widerstand des Leistungsmoduls um 25 -30% verringert, vorzugsweise halbiert.

Die durchgehende Verwendung des Drucksinterverfahrens als Verbindungstechnik für den Aufbau des Leistungsmoduls erhöht gegenüber einem in konventioneller Löttechnik aufgebauten Leistungsmodul entscheidend dessen Lastwechselfestigkeit gegenüber thermischen Lastwechsel. Bei thermischen Lastwechseln im Temperaturbereich von minus 55°C bis 125°C kann mit einem in Drucksinterverbindungstechnik aufgebauten Leistungsmodul eine Steigerung der Lastwechselfestigkeit um mindestens dem Faktor 12 gegenüber einem im Lötverbindung aufgebauten Leistungsmodul erzielt werden.

Im Gegensatz zu Weichlötprozessen entsteht die Sinterverbindung infolge einer Festkörperreaktion. Das hat zur Folge, daß die Drucksinterverbindung, die bei einer Prozesstemperatur im Bereich von 215 °C bis 250°C hergestellt wird, bei gleichen oder sogar deutlich höheren Betriebstemperaturen eingesetzt werden kann. Einerseits ist daher eine nachfolgende Montage von Komponenten bei gleicher Prozeßtemperatur möglich, so daß Probleme wie das Löten mit Loten unterschiedlicher Sclunelztemperatur entfallen. Andererseits ist die Drucksintertechnik auch für den Aufbau zukünftiger Leistungsbauelementgenerationen auf SiC-Basis (Siliziumkarbid-Basis) einsetzbar, ohne daß hierzu Modifikationen in der Prozeßtechnologie notwendig sind.

Ein weiterer Vorteil liegt in der Qualität einer Drucksinterverbindung. Insbesondere bei großen Flächen sind in Lötverbindungen oftmals Lunker (Lufteinschlüsse) vorhanden. Teilweise nehmen die Lunker bis zu 50% der Lotverbindung ein und verursachen somit einen Anstieg des thermischen Widerstandes. Die Drucksinterverbindung läßt sich dagegen auch für große Flächen mit geringer Schichtdicke von kleiner 30 Mikrometern in lunkerfreier Qualität fertigen.

Ausführungsbeispiele der Erfindung werden im folgenden anhand von Zeichnungen dargestellt und näher erläutert. Es zeigen:
- Fig. 1: einen schematischen Aufbau eines wassergekühlten erfindungsgemäßen Leistungsmoduls mit oberseitig montierten Wärmekapazitäten aus Molybdaen,
- Fig. 2: einen schematischen Aufbau eines wassergekühlten erfindungsgemäßen Leistungsmoduls mit oberseitig montierter DCB-Keramik,

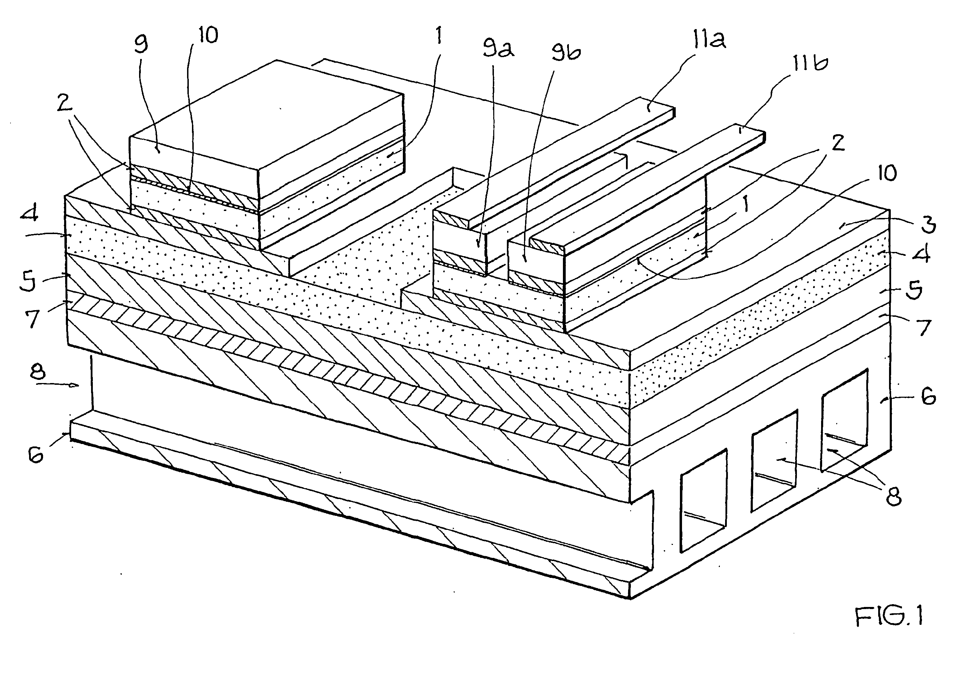

In Fig. 1 sind zwei elektronische Leistungsbauelemente 1, vorzugsweise Halbleiterleistungsbauelemente, mit einer Drucksinterschicht 2 auf einer Kupferschicht 3 aufgebracht. Die Kupferschicht 3 dient der elektrischen Kontaktierung der Leistungsbauelemente an deren Unterseite. Hierzu kann die Kupferschicht zur Ausbildung mehrerer getrennter Leiterbahnen strukturiert oder unterbrochen sein. Dadurch können auch mehrere Leistungsbauelemente unabhängig von einander kontaktiert werden. Die Kupferschicht 3 ist Bestandteil einer sogenannten DCB-Keramik (Direct Copper Bonding Keramik). Die DCB-Keramik besteht aus einer oberen Kupferschicht 3, einer Keramikschicht 4 und einer unteren Kupferschicht 5. Die Keramikschicht 4 ist beispielsweise aus Aluminiumoxid, vorzugsweise aus Al₂O₃, gebildet. Die untere Kupferschicht dient der weiteren Verbindung des Aufbaus mit einem Kupferkühlkörper 6. Auch diese Verbindung wird mit einer weiteren Drucksinterschicht 7 hergestellt. Vorzugsweise ist der Kupferkühlkörper mit Kühlkanälen 8 ausgestaltet, so daß auch hohe Verlustleistungen mit einem Kühlmedium, das in den Kühlkanälen fließt, abgeführt werden können. Der Kupferkühlkörper 6 übernimmt hauptsächlich die stationäre Kühlung der Leistungsbauelemente 1. Für kurzzeitig auftretende transiente Wärmebelastungen der Leistungsbauelemente sind an der Oberseite der Leistungsbauelemente zusätzliche Wärmekapazitäten 9,9a,9b angebracht. Auch diese Wärmekapazitäten sind mit einer Drucksinterschicht 10 auf den Leistungsbauelementen 1 angebracht. In einer bevorzugten Ausführungsform sind die Wärmekapazitäten 9 aus Molybdän gefertigt.

Die Drucksinterverbindungsschichten 2,7,10 werden hergestellt, indem auf mindestens eine der jeweilig zu verbindenden Flächen ein in einem Lösungsmittel aufgeschlämmtes Silberpulver aufgebracht wird. Anschließend wird das Aufschlämmittel bei einer Temperatur von 150°C bis 250°C verdampft. Die zu verbindenden Flächen werden aufeinander gelegt und die Silberschicht wird bei 215 °C bis 250 °C und 40 MPa über eine Dauer von 1 bis 2 Minuten in einer Presse versintert. In der Presse wird der Druck über einen Silikonkautschuk an die Bauelemente angekoppelt, um hydrostatische Verhältnisse zu erreichen.

Die zu verbindenden Flächen müssen für die Anwendung von Drucksinterverfahren oxidfrei sein. Es empfiehlt sich deshalb vor dem Verbinden der Flächen eine entsprechende Behandlung der Flächen um eventuell vorhandene Oxidschichten zu entfernen. Ein andere Möglichkeit ist es, die miteinander zu verbindenden Bauteile jeweils mit einer Edelmetallschicht, wie Silber oder Gold, zu metallisieren. Ein Vergoldung verhindert zuverlässig auch über eine längere Lagerzeit der einzelnen Bauteile das Entstehen von Oxidschichten auf den Oberflächen der Bauteile. In einer besonders bevorzugten Ausführung eines Leistungsmoduls sind deshalb die Leistungsbauelemente 1, die DCB-Keramik 3,4,5, der Kupferkühlkörper 6 sowie die Wärmekapazitäten 9,9a,9b,12 jeweils vergoldet.

Zur weiteren Kontaktierung der Leistungsbauelemente an deren Oberseite können auf die Wärmekapazitäten 9, 9a, 9b elektrische Kontakte 11a, 11b angebracht sein. Falls mehrere Kontakte an der Oberseite angebracht werden sollen, empfiehlt es sich, auch mehrere getrennte Wärmekapazitäten an der Oberseite anzubringen, da ansonsten die verschiedenen Kontakte 11a, 11b durch eine einzige Wärmekapazität aus Molybdän kurzgeschlossen würden. Die zusätzlichen Kontakte an der Oberseite des Leistungsmoduls können in herkömmlicher Bonddrahttechnologie ausgeführt werden. Ein Aufschmelzen der Drucksinterschichten im Leistungsmodulaufbau ist hierbei, wie eingangs erläutert, nicht zu befürchten. Wann immer möglich, empfiehlt sich jedoch auch für die Kontakte 11a, 11b die Drucksintertechnik. In der Fig. 1 sind die oberen elektrischen zusätzlichen Kontakte 11a, 11b deshalb als Kupferlaschen ausgebildet, die ebenfalls im Drucksinterverfahren mit dem Leistungsmodul verbunden sind. Auf eine Darstellung der herkömmlichen Bonddrahtkontaktierungen wurde verzichtet. Flächige Drucksinterverbindungen der Kupferlaschen an den Molybdän-Wärmekapazitäten fördern zusätzlich die Wärmeableitung aus den Wärmekapazitäten in die Kupferlaschen.

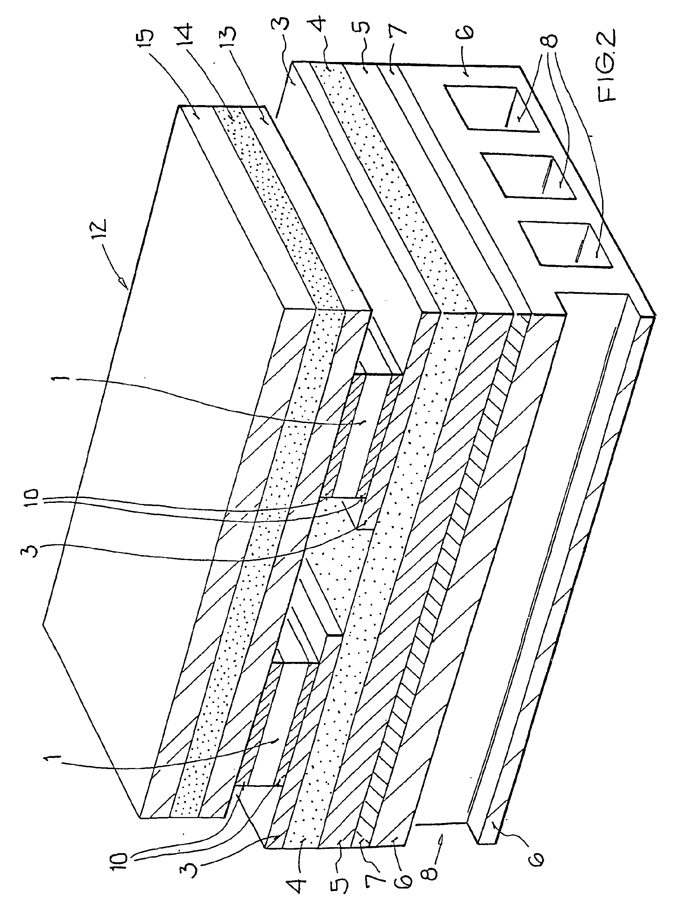

In dem Ausführungsbeispiel der Fig. 2 sind die drei getrennten Molybdän-Wärmekapazitäten aus Fig. 1 durch eine einteilige Wärmekapazität 12 in Form einer DCB-Keramik ersetzt. Auch diese DCB-Keramik ist aus einer unteren Kupferschicht 13, einer Keramikschicht 14 und einer oberen Kupferschicht 15 gebildet. Auch in diesem Ausführungsbeispiel ist die einteilige Wärmekapazität 12 mit Drucksinterschichten 10 an der Oberseite der elektronischen Leistungsbauelemente 1 angebracht. Zur Kontaktierung der Leistungsbauelemente 1 an deren Oberseite, kann die untere Kupferschicht 13 der DCB-Keramik strukturiert und unterbrochen sein, so daß in der Kupferschicht Leiterbahnen zur getrennten Kontaktierung der Leistungsbauelemente gebildet werden. Die Ausbildung einer einteiligen Wärmekapazität hat Vorteile beim Aufbau des Leistungsmoduls, da lediglich ein Bauteil mit der Oberseite der Leistungsbauelemente verbunden werden muß. Der Einsatz der oberseitig motierten DCB-Keramik zur elektrischen Verschaltung der Leistungsbauelemente ergibt zudem eine niederinduktive Kontaktierung der Leistungsbauelemente, so daß Schaltverluste vermindert werden und die Schaltzeiten der Leistungsbauelemente verkürzt werden. Die DCB- Keramiken sind bevorzugt mit Aluminium-Silizium-Karbid (AlSiC) Keramiken gebildet.

Laborversuche haben ergeben, daß für die Molybdaen-Wärmekapazitäten aus dem Ausführungsbeispiel der Fig. 1 Schichtdicken von 2 Millimetern bis 3 Millimetern besonders vorteilhaft sind. Mit Molybdän- Wärmekapazitäten einer Stärke von 2 Millimetern Lassen sich sowohl der transiente thermische Widerstand als auch der stationäre thermische Widerstand, eines erfindungsgemäßen Leistungsmoduls im Vergleich zu einem herkömmlich aufgebauten Leistungsmodul in Lötverbindungstechnik und ohne zusätzliche Wärmekapazitäten halbieren. Der transiente thermische Widerstand ist hierbei definiert als das Verhältnis des maximalen Temperaturhubes des Leistungsbauelementes bei einer transienten Wärmebelastung zur zeitlichen gemittelten stationären Verlustleistung. Die Halbierung der thermischen Widerstände erlaubt die Verdoppelung der Verlustleistungsdichte, mit der der erfindungsgemäße Leistungsmodul im Vergleich mit einem herkömmlichen Leistungsmodul betrieben werden kann.

Auch mit der oberseitig angeordneten Wärmekapazität aus DCB-Keramik entsprechend dem Ausführungsbeispiel der Figur 2 werden die thermischen Widerstände deutlich verbessert. Um für eine Wärmekapazität aus DCB-Keramik eine Halbierung der thermischen Widerstände zu erzielen, muß jedoch zwischen der oberseitig angeordneten DCB-Keramik und den Leistungsbauelementen eine 0,8 Millimeter starke Molybdänschicht angebracht werden.

Ein im Drucksinterverfahren aufgebautes Leistungsmodul ist besonders geeignet zum Einsatz in hohen Umgebungstemperaturen und bei Umgebungsbedingungen, bei denen viele thermische Lastwechsel stattfinden. Eine Umgebung mit für Halbleiterbauelemente hohen Temperaturen und mit häufigen thermischen Lastwechseln findet sich beispielsweise in der unmittelbaren Umgebung einer Verbrennungsmaschine, beispielsweise im Motorraum eines Kraftfahrzeuges. In dieser Anwendung sind die Leistungsbauelemente vorteilhafterweise SiC-Leistungsbauelemente. Siliziumkarbid basierte Halbleiterbauelemente weisen die notwendige thermische Stabilität für Hochtemperaturanwendungen bis ca 250 °C auf.

## Patentansprüche

1. Elektronisches Leistungsmodul mit mindestens einem elektronischen Leistungsbauelement (1), einem Substrat, einem Kühlkörper (6) und mindestens einer zusätzlichen Wärmekapazität (9, 9a, 9b, 12),
**dadurch gekennzeichnet, dass**
das Substrat ein DCB-Keramiksubstrat (3,4,5) ist, wobei
a) die elektronischen Leistungsbauelemente (1) über eine Sinterschicht (2) an ihrer Unterseite mit der oberen Kupferschicht (3) des DCB-Keramiksubstrates verbunden sind,
b) die obere Kupferschicht (3) des DCB-Keramiksubstrates zur elektrischen Kontaktierung der Leistungsbauelemente (1) in Kupferleiterbahnen strukturiert ist,
c) die untere Kupferschicht (5) des DCB-Keramiksubstrates über eine Sinterschicht (7) mit dem Kühlkörper (6) verbunden ist,
d) die Oberseite der Leistungsbauelemente (1) über eine Sinterschicht (10) mit mindestens einer zusätzlichen Wärmekapazität (9,9a, 9b, 12) verbunden sind.

2. Leistungsmodul nach Anspruch 1, bei dem die zusätzlichen Wärmekapazitäten (9, 9a, 9b) aus Molybdän sind.

3. Leistungsmodul nach Anspruch 1, bei dem die zusätzliche Wärmekapazität (12) eine DCB-Keramik ist.

4. Leistungsmodul nach Anspruch 1, bei dem die zusätzliche Wärmekapazität (9, 9a, 9b, 12) aus dem Verbundwerkstoff AlSiC gebildet ist.

5. Leistungsmodul nach Anspruch 3, bei dem zwischen der Wärmekapazität (12) und den Leistungsbauelementen (1) jeweils eine Molybdänschicht angeordnet ist.

6. Leistungsmodul nach Anspruch 1, bei dem die Leistungsbauelemente (1) jeweils über die zusätzlichen Wärmekapazität (9, 9a, 9b, 12) an ihrer Oberseite kontaktiert werden.

7. Leistungsmodul nach Anspruch 6, bei dem die Kontaktierung der Leistungsbauelemente (1) an ihrer Oberseite mittels Bonddrahtkontaktierung erfolgt.

8. Leistungsmodul nach Anspruch 6, bei dem die Kontaktierung der Leistungsbauelemente (1) mittels Kupferlaschen (11a, 11b) erfolgt, die mit einer Sinterschicht mit den zusätzlichen Wärmekapazitäten (9a, 9b) verbunden sind.

9. Leistungsmodul nach Anspruch 3, bei dem die Kontaktierung der Leistungsbauelemente (1) mittels der unteren Kupferschicht (13) der zusätzlichen Wärmekapazität (12) erfolgt, die als DCB-Keramik ausgebildet ist.

10. Leistungsmodul nach einem der Ansprüche 1 bis 9, bei dem der Kühlkörper (6) ein Kupferkühlkörper ist.

11. Leistungsmodul nach einem der Ansprüche 1 bis 9, bei dem der Kühlkörper (6) zusätzlich Kühlkanäle (8) aufweist, in denen ein Kühlmedium zur Aufnahme der Verlustwärme der Leistungsbauelemente (1) fliesst.

12. Leistungsmodul nach einem der Ansprüche 1 bis 11, bei dem die Leistungsbauelemente (1) SiC-Leistungsbauelemente sind.

## Claims

1. Electronic power module having at least one electronic power device (1), a substrate, a heat sink (6) and at least one additional thermal capacitance (9, 9a, 9b, 12),
**characterized in that** the substrate is a DCB ceramic substrate (3, 4, 5),
a) the electronic power devices (1) being connected by means of a sintered layer (2) on their underside to the upper copper layer (3) of the DCB ceramic substrate,
b) the upper copper layer (3) of the DCB ceramic substrate being structured into copper conductor tracks for the electrical contacting of the power devices (1),
c) the lower copper layer (5) of the DCB ceramic substrate being connected by means of a sintered layer (7) to the heat sinks,
d) the upper sides of the power devices (1) being connected by means of a sintered layer (10) to at least one additional thermal capacitance (9, 9a, 9b, 12).

2. Power module according to Claim 1, in which the additional thermal capacitances (9, 9a, 9b) are made of molybdenum.

3. Power module according to Claim 1, in which the additional thermal capacitance (12) is a DCB ceramic.

4. Power module according to Claim 1, in which the additional thermal capacitance (9, 9a, 9b, 12) is formed from the composite material AlSiC.

5. Power module according to Claim 3, in which a molybdenum layer is respectively arranged between the thermal capacitance (12) and the power devices (1).

6. Power module according to Claim 1, in which the power devices (1) are respectively contacted on their upper side by means of the additional thermal capacitance (9, 9a, 9b, 12).

7. Power module according to Claim 6, in which the contacting of the power devices (1) takes place on their upper side by means of bonding wire contacting.

8. Power module according to Claim 6, in which the contacting of the power devices (1) takes place by means of copper lugs (11a, 11b), which are connected to the additional thermal capacitances (9a, 9b) by a sintered layer.

9. Power module according to Claim 3, in which the contacting of the power devices (1) takes place by means of the lower copper layer (13) of the additional thermal capacitance (12), which is formed as a DCB ceramic.

10. Power module according to one of Claims 1 to 9, in which the heat sink (6) is a copper heat sink.

11. Power module according to one of Claims 1 to 9, in which the heat sink (6) additionally has cooling channels (8), in which a cooling medium for absorbing the dissipated heat of the power devices (1) flows.

12. Power module according to one of Claims 1 to 11, in which the power devices (1) are SiC power devices.

## Revendications

1. Module électronique de puissance ayant au moins un composant (1) électronique de puissance, un substrat, un dissipateur (6) de chaleur et au moins une capacité (9, 9a, 9b, 12) calorifique supplémentaire,
**caractérisé en ce que** le substrat est un substrat (3, 4, 5) céramique DCB, dans lequel
a) les composants (1) électroniques de puissance sont reliés par une couche (2) de frittage à leur côté inférieur à la couche (3) supérieure de cuivre du substrat céramique DCB,
b) la couche (3) supérieure de cuivre du substrat céramique DCB est structurée pour la mise en contact électrique des composants (1) de puissance en des pistes conductrices en cuivre,
c) la couche (5) inférieure de cuivre du substrat céramique DCB est reliée au dissipateur (6) de chaleur par une couche (7) de frittage,
d) les côtés supérieurs des composants (1) de puissance sont reliés par une couche (10) de frittage à au moins une capacité (9, 9a, 9b, 12) calorifique supplémentaire.

2. Module de puissance suivant la revendication 1, dans lequel les capacités (9, 9a, 9b) calorifiques supplémentaires sont en molybdène.

3. Module de puissance suivant à revendication 1, dans lequel la capacité (12) calorifique supplémentaire est une céramique DCB.

4. Module de puissance suivant la revendication 1, dans lequel la capacité (9, 9a, 9b, 12) calorifique supplémentaire est en le matériau composite AlSiC.

5. Module de puissance suivant la revendication 3, dans lequel respectivement une couche de molybdène est disposée entre la capacité (12) calorifique et les composants (1) de puissance.

6. Module de puissance suivant la revendication 1, dans lequel les composants (1) de puissance sont contactés sur leur côté supérieur respectivement par la capacité (9, 9a, 9b, 12) calorifique supplémentaire.

7. Module de puissance suivant la revendication 6, dans lequel la mise en contact des composants (1) de puissance s'effectue sur leur côté supérieur au moyen d'une mise en contact par fil de liaison.

8. Module de puissance suivant la revendication 6, dans lequel la mise en contact des composants (1) de puissance s'effectue au moyen de languettes (11a, 11b) de cuivre, qui sont reliées par une couche de frittage aux capacités (9a, 9b) calorifiques supplémentaires.

9. Module de puissance suivant la revendication 3, dans lequel la mise en contact des composants (1) de puissance s'effectue au moyen de la couche (13) inférieure de cuivre de la capacité (12) calorifique supplémentaire, laquelle est constituée sous la forme d'une céramique DCB.

10. Module de puissance suivant l'une des revendications 1 à 9, dans lequel le dissipateur (6) de chaleur est un dissipateur de chaleur au cuivre.

11. Module de puissance suivant l'une des revendications 1 à 9, dans lequel le dissipateur (6) de chaleur a en outre des canaux (8) de refroidissement, dans lesquels passe un fluide de refroidissement pour absorber la chaleur perdue des composants (1) de puissance.

12. Module de puissance suivant l'une des revendications 1 à 11, dans lequel les composants (1) de puissance sont des composants de puissance en SiC.
